# EUROPEAN PATENT SPECIFICATION

(11) **EP 3 397 789 B1**
(45) Date of publication and mention of the grant of the patent: **02.09.2020**
(21) Application number: 16882292.2
(22) Date of filing: 12.12.2016
(51) Int. Cl.: C23C 16/14, C23C 16/06, C23C 16/34, C23C 16/455, C23C 16/18, C23C 16/30, C23C 16/42

(54) **MANGANESE-CONTAINING FILM FORMING COMPOSITIONS, THEIR SYNTHESIS, AND USE IN FILM DEPOSITION**
MANGANHALTIGE FILMBILDENDE ZUSAMMENSETZUNGEN, DEREN SYNTHESE UND VERWENDUNG BEI DER FILMABSCHEIDUNG
COMPOSITIONS FILMOGÈNES CONTENANT DU MANGANÈSE, LEUR SYNTHÈSE ET LEUR UTILISATION DANS LE DÉPÔT DE FILMS

(30) Priority: 31.12.2015 US 201514986313
(43) Date of publication of application: 07.11.2018
(73) Proprietor: L'Air Liquide Société Anonyme pour l'Etude et l'Exploitation des Procédés Georges Claude, 75007 Paris (FR)
(72) Inventor: WIESE, Stefan, Wilmington Delaware 19801 (US); GATINEAU, Satoko, Seoul Gyeonggi-do 06580 (KR); DUSSARRAT, Christian, Tokyo 120-0223 (JP); GIRARD, Jean-Marc, 78000 Versailles (FR); BLASCO, Nicolas, 38130 Echirolles (FR)
(74) Representative: Grout de Beaufort, François-Xavier
(86) International application number: PCT/US2016/066120
(87) International publication number: WO 2017/116665

(56) References cited:
- WO-A1-2014/134481
- WO-A1-2017/093283
- JP-A- 2004 131 485
- US-A1- 2009 087 561
- SONJA N. KÖNIG ET AL: "Silylamide Complexes of Chromium(II), Manganese(II), and Cobalt(II) Bearing the Ligands N(SiHMe 2 ) 2 and N(SiPhMe 2 ) 2", INORGANIC CHEMISTRY, vol. 53, no. 9, 24 April 2014 (2014-04-24) , pages 4585-4597, XP055602805, EASTON, US ISSN: 0020-1669, DOI: 10.1021/ic5002682
- BAXTER D V: "LOW PRESSURE CHEMICAL VAPOR DEPOSITION OF METALLIC FILMS OF IRON, MANGANESE, COBALT, COPPER, GERMANIUM AND TIN EMPLOYING BIS(TRIMETHYL)SILYLAMIDO COMPLEXES, M(N(SIME3)2)N", CHEMICAL VAPOR DEPOSITION, WILEY-VCH VERLAG, WEINHEIM, DE, vol. 7, no. 9, 1 September 1995 (1995-09-01), pages 49-51, XP000520472, ISSN: 0948-1907, DOI: 10.1002/CVDE.19950010203

## Description

### Technical field

Manganese-containing film forming compositions, their preparation, and their use for the vapor deposition of films are disclosed. The manganese-containing film forming compositions comprise silylamide-containing precursors, particularly {Mn[N(SiMe₂Et)₂]₂}₂.

### Background

Chemical Vapor Deposition (CVD) and Atomic Layer Deposition (ALD) have been applied as main deposition techniques for producing thin films for semiconductor devices. These methods enable the achievement of conformal films (metal, oxide, nitride, silicide, etc.) through fine tuning of parameters during the deposition processes. Mainly the film growth is controlled by chemical reactions of metal-containing compounds (precursors) and the development of optimum precursors is essential under prediction of their properties and reaction processes.

Films of transition metals and transition metal silicides, particularly cobalt, iron, manganese, and ruthenium, are becoming important for a variety of electronics and electrochemical applications. For example, manganese thin films are of interest due to their high magnetic permittivity. There are many reports of using manganese thin films to form manganese disilicide (MnSi₂) for Ohmic contacts owing to its low resistivity in front-end-of-the-line processing of semiconductor devices. Manganese containing thin films were recently studied as Cu/low-k self forming barriers, passivation layers, and capping layers for ultralarge scale integrated devices. See, e.g., US Pat. No. 9,362,228 to Chae et al. and Gordon et al., Chemical vapor deposition (CVD) of manganese self-aligned diffusion barrier for Cu interconnections in microelectronics. In Advanced Metallization Conference 2008.

Synthesis of silylamide compounds has been reported (Monatsh. Chem. (1964), 95, pp. 1099-1102; Inorganic Chemistry, Vol. 23, No. 26, 1984, 4585; Polyhedron 9 (1990) p.2959). Vapor deposition film formation using silylamide compounds has also been reported (Chem.Vap. Deposition 1995, 1, No. 2, 49-51; US 6969539B2, R.G.Gordon et al; US 2009/0053426A1 Applied Materials; US 2014/255606 Applied Materials).

US 6969539 to Gordon et al. discloses:

| Compound | Melt Pt (°C) | Vapor Press (°C/Torr) | Ref/Comm Source |
|---|---|---|---|
| Mn(N(SiBuMe₂)₂)₂ | liquid | 143/0.6 | Broomhall-Dillard & Gordon, 1999 |
| Mn(N(SiMe₂)₂)₂ | 55-60 | 112-120/0.2 | Bradley, Trans, Met. Chem. 3, 253 (1978) |
| Mn(N(SiMe₂)₂)₂ | 108-110 | | Power, JACS 11, 8044 (1989) |

One of ordinary skill in the art will recognize that while the liquid form of Mn(N(SiBuME₂)₂)₂ is favorable for vapor deposition methods, the vapor pressure is too low for industrial usage for thin film deposition. Further relevant prior art is disclosed in the following documents:
WO 2017/093283 A1 (prior art under Article 54(3) EPC),
SONJA N. KONIG ET AL: "Silylamide Complexes of Chromium(II), Manganese(II), and Cobalt(II) Bearing the Ligands N(SiHMe 2) 2 and N(SiPhMe 2) 2",INORGANIC CHEMISTRY, vol. 53, no. 9, 24 April 2014 (2014-04-24), pages 4585-4597,
BAXTER D V: "LOW PRESSURE CHEMICAL VAPOR DEPOSITION OF METALLIC FILMS OF IRON, MANGANESE, COBALT, COPPER, GERMANIUM AND TIN EMPLOYING BIS(TRIMETHYL)SILYLAMIDO COMPLEXES, M(N(SIME3)2)N",CHEMICAL VAPOR DEPOSITION, WILEY-VCH VERLAG, WEINHEIM, DE, vol. 7, no. 9, 1 September 1995 (1995-09-01), pages 49-51.

Selecting a Mn-containing precursor that is suitably volatile while remaining stable enough for use in vapor phase film deposition is important for commercial implementation and not always easily determined.

### Summary

The invention is defined by the appended claims.

According to the invention the silylamide-containing precursor is {Mn[N(SiMe₂Et)₂]₂}₂ or Mn[N(SiMe₃)₂]₂NMeEt₂).

The disclosed silylamide-containing film forming compositions may have one or more of the following aspects:
- the manganese-containing film forming composition comprising between approximately 99% w/w and approximately 100% w/w of the silylamide-containing precursor;
- the manganese-containing film forming composition comprising between approximately 99% w/w and approximately 100% w/w of the silylamide-containing precursor after 4 weeks at 50°C;
- the manganese-containing film forming composition comprising between approximately 99% w/w and approximately 100% w/w of the silylamide-containing precursor after 12 weeks at room temperature (approximately 23°C);
- the manganese-containing film forming composition producing less than 3% residual mass under thermogravimetric analysis after 2 weeks of stability testing at a temperature that produces 1 Torr vapor pressure of the silylamide-containing precursor;
- the manganese-containing film forming composition producing less than 3% residual mass under thermogravimetric analysis after 3 weeks of stability testing at a temperature that produces 1 Torr vapor pressure of the silylamide-containing precursor;
- the manganese-containing film forming composition producing less than 3% residual mass under thermogravimetric analysis after 2 months of stability testing at a temperature that produces 1 Torr vapor pressure of the silylamide-containing precursor;
- the manganese-containing film forming composition comprising between approximately 95% w/w and approximately 100% w/w of the silylamide-containing precursor;
- the Mn-containing film forming composition comprising between approximately 5 % w/w and approximately 50% w/w of the silylamide-containing precursor;
- the Mn-containing film forming composition comprising no water;
- the Mn-containing film forming composition comprising between approximately 0 % w/w and approximately 5% w/w impurities;
- the Mn-containing film forming composition comprising between approximately 0.0% w/w and approximately 2.0% w/w impurities;
- the Mn-containing film forming composition comprising between approximately 0.0% w/w and approximately 1.0% w/w impurities;
- the impurities including halides, alkali metals, alkyl-substituted silanes, lithium, sodium, or potassium halides; THF; ether; pentane; cyclohexane; heptanes; benzene; toluene;
- the Mn-containing film forming composition comprising between approximately 0 ppbw and approximately 1 ppmw metal impurities;
- the Mn-containing film forming composition comprising between approximately 0 ppbw and approximately 500 ppbw metal impurities;
- the Mn-containing film forming composition comprising between approximately 0 ppbw and approximately 100 ppbw Al;
- the Mn-containing film forming composition comprising between approximately 0 ppbw and approximately 100 ppbw As;
- the Mn-containing film forming composition comprising between approximately 0 ppbw and approximately 100 ppbw Ba;
- the Mn-containing film forming composition comprising between approximately 0 ppbw and approximately 100 ppbw Be;
- the Mn-containing film forming composition comprising between approximately 0 ppbw and approximately 100 ppbw Bi;
- the Mn-containing film forming composition comprising between approximately 0 ppbw and approximately 100 ppbw Cd;
- the Mn-containing film forming composition comprising between approximately 0 ppbw and approximately 100 ppbw Ca;
- the Mn-containing film forming composition comprising between approximately 0 ppbw and approximately 100 ppbw Cr;
- the Mn-containing film forming composition comprising between approximately 0 ppbw and approximately 100 ppbw Co;
- the Mn-containing film forming composition comprising between approximately 0 ppbw and approximately 100 ppbw Cu;
- the Mn-containing film forming composition comprising between approximately 0 ppbw and approximately 100 ppbw Ga;
- the Mn-containing film forming composition comprising between approximately 0 ppbw and approximately 100 ppbw Ge;
- the Mn-containing film forming composition comprising between approximately 0 ppbw and approximately 100 ppbw Hf;
- the Mn-containing film forming composition comprising between approximately 0 ppbw and approximately 100 ppbw Zr;
- the Mn-containing film forming composition comprising between approximately 0 ppbw and approximately 100 ppbw In;
- the Mn-containing film forming composition comprising between approximately 0 ppbw and approximately 100 ppbw Fe;
- the Mn-containing film forming composition comprising between approximately 0 ppbw and approximately 100 ppbw Pb;
- the Mn-containing film forming composition comprising between approximately 0 ppbw and approximately 100 ppbw Li;
- the Mn-containing film forming composition comprising between approximately 0 ppbw and approximately 100 ppbw Mg;
- the Mn-containing film forming composition comprising between approximately 0 ppbw and approximately 100 ppbw W;
- the Mn-containing film forming composition comprising between approximately 0 ppbw and approximately 100 ppbw Ni;
- the Mn-containing film forming composition comprising between approximately 0 ppbw and approximately 100 ppbw K;
- the Mn-containing film forming composition comprising between approximately 0 ppbw and approximately 100 ppbw Na;
- the Mn-containing film forming composition comprising between approximately 0 ppbw and approximately 100 ppbw Sr;
- the Mn-containing film forming composition comprising between approximately 0 ppbw and approximately 100 ppbw Th;
- the Mn-containing film forming composition comprising between approximately 0 ppbw and approximately 100 ppbw Sn;
- the Mn-containing film forming composition comprising between approximately 0 ppbw and approximately 100 ppbw Ti;
- the Mn-containing film forming composition comprising between approximately 0 ppbw and approximately 100 ppbw U;
- the Mn-containing film forming composition comprising between approximately 0 ppbw and approximately 100 ppbw V;
- the Mn-containing film forming composition comprising between approximately 0 ppbw and approximately 100 ppbw Zn;
- the Mn-containing film forming composition comprising between approximately 0 ppmw and approximately 100 ppmw Cl;
- the Mn-containing film forming composition comprising between approximately 0 ppmw and approximately 100 ppmw Br.

Also disclosed is a Mn-containing film forming composition delivery device comprising a canister having an inlet conduit and an outlet conduit and containing any of the Mn-containing film forming compositions disclosed above. The disclosed device may include one or more of the following aspects:
- the Mn-containing film forming composition having a total concentration of metal contaminants of less than 10 ppmw;
- an end of the inlet conduit end located above a surface of the Mn-containing film forming composition and an end of the outlet conduit located below the surface of the Mn-containing film forming composition;
- an end of the inlet conduit end located below a surface of the Mn-containing film forming composition and an end of the outlet conduit located above the surface of the Mn-containing film forming composition;
- further comprising a diaphragm valve on the inlet and the outlet;
- further comprising one or more barrier layers on an interior surface of the canister;
- further comprising one to four barrier layers on an interior surface of the canister;
- further comprising one or two barrier layers on an interior surface of the canister;
- each barrier layer comprising a silicon oxide layer, silicon nitride layer, silicon oxynitride layer, silicon carbonitride, silicon oxycarbonitride layer, or combinations thereof;
- wherein each barrier layer is 5 to 1000 nm in thickness;
- wherein each barrier layer is 50 to 500 nm in thickness;
- the Mn-containing film forming composition comprising {Mn[N(SiMe₂Et)₂]₂}₂.

Also disclosed are methods of depositing a Mn-containing layer on a substrate. The vapor of any of the Mn-containing film forming compositions disclosed above is introduced into a reactor having a substrate disposed therein. At least part of the silylamide-containing precursor is deposited onto the substrate to form a Mn-containing layer using a vapor deposition method. According to the invention the Mn-containing film forming compositions comprises a silylamide-containing precursor selected from {Mn[N(SiMe₂Et)₂]₂}₂ or Mn[N(SiMe₃)₂]₂NMeEt₂).

The disclosed methods may have one or more of the following aspects:
- introducing into the reactor a vapor comprising a second precursor;
- an element of the second precursor being selected from the group consisting of group 2, group 13, group 14, transition metal, lanthanides, and combinations thereof;
- the element of the second precursor being selected from Mg, Ca, Sr, Ba, Zr, Hf, Ti, Nb, Ta, Al, Si, Ge, Y, or lanthanides;
- introducing a reactant into the reactor;
- the reactant being selected from the group consisting of O₂, O₃, H₂O, H₂O₂, NO, NO₂, a carboxylic acid, radicals thereof, and combinations thereof;
- the reactant being plasma treated oxygen;
- the reactant being ozone;
- the reactant being selected from the group consisting of H₂, NH₃, (SiH₃)₃N, hydridosilanes (such as SiH₄, Si₂H₆, Si₃H₈, Si₄H₁₀, Si₅H₁₀, Si₆H₁₂), chlorosilanes and chloropolysilanes (such as SiHCl₃, SiH₂Cl₂, SiH₃Cl, Si₂Cl₆, Si₂HCl₅, Si₃Cl₈), alkysilanes (such as Me₂SiH₂, Et₂SiH₂, MeSiH₃, EtSiH₃), hydrazines (such as N₂H₄, MeHNNH₂, MeHNNHMe), organic amines (such as NMeH₂, NEtH₂, NMe₂H, NEt₂H, NMe₃, NEt₃, (SiMe₃)₂NH), pyrazoline, pyridine, B-containing molecules (such as B₂H₆, 9-borabicylo[3,3,1]none, trimethylboron, triethylboron, borazine), alkyl metals (such as trimethylaluminum, triethylaluminum, dimethylzinc, diethylzinc), radical species thereof, and mixtures thereof;
- the reactant being selected from the group consisting of H₂, NH₃, SiH₄, Si₂H₆, Si₃H₈, SiH₂Me₂, SiH₂Et₂, N(SiH₃)₃, hydrogen radicals thereof, and mixtures thereof;
- the reactant being selected from the group consisting of NH₃, N₂H₄, N(SiH₃)₃, N(CH₃)H₂, N(C₂H₅)H₂, N(CH₃)₂H, N(C₂H₅)₂H, N(CH₃)₃, N(C₂H₅)₃, (SiMe₃)₂NH, (CH₃)HNNH₂, (CH₃)₂NNH₂, nitrogen-containing radical species thereof, and mixtures thereof;
- the reactant being HCDS or PCDS;
- the reactant being plasma treated N₂;
- the vapor deposition method being a CVD process;
- the vapor deposition method being an ALD process;
- the vapor deposition method being a PEALD process;
- the vapor deposition method being a spatial ALD process;
- the Mn-containing layer being a manganese oxide layer;
- the Mn-containing layer being a manganese nitride layer;
- the Mn-containing layer being Mn; and
- the Mn-containing layer being MnSi.

Also disclosed are methods of depositing a manganese silicate self forming barrier layer on a substrate. The vapor of any of the Mn-containing film forming compositions disclosed above is introduced into a reactor having a substrate disposed therein, the substrate having a via formed in a silicon-based insulating layer thereon, the silicon-based insulating layer forming sidewalls of the via and a metal line forming a bottom of the via. At least part of the silylamide-containing precursor is deposited onto the sidewalls, but not the bottom of the via, to form a manganese silicate self forming layer using a vapor deposition method. According to the invention the Mn-containing film forming compositions comprises a silylamide-containing precursor selected from {Mn[N(SiMe2Et)2]2}2 or Mn[N(SiMe3)2]2NMeEt2). The disclosed methods may have one or more of the following aspects:
- the via having an aspect ratio ranging from approximately 3:1 to approximately 20:1;
- the silicon-based insulating layer containing Si and O;
- the silicon-based insulating layer being thermally oxidized silicon;
- the silicon-based insulating layer being SiO₂;
- the silicon-based insulating layer being SiOC;
- the silicon based insulating layer being porous SiOC;
- the metal line being copper;
- the vapor deposition method being a CVD process;
- the vapor deposition method being an ALD process;
- the vapor deposition method being a PEALD process;
- the vapor deposition method being a spatial ALD process; and
- annealing the substrate.

### Notation and Nomenclature

Certain abbreviations, symbols, and terms are used throughout the following description and claims, and include:
As used herein, the indefinite article "a" or "an" means one or more.
As used herein, the terms "approximately" or "about" mean ±10% of the value stated.
Any and all ranges recited herein are inclusive of their endpoints (i.e., x=1 to 4 includes x=1, x=4, and x=any number in between).
As used herein, the term "alkyl group" refers to saturated functional groups containing exclusively carbon and hydrogen atoms. Further, the term "alkyl group" refers to linear, branched, or cyclic alkyl groups. Examples of linear alkyl groups include without limitation, methyl groups, ethyl groups, propyl groups, butyl groups, etc. Examples of branched alkyls groups include without limitation, t-butyl. Examples of cyclic alkyl groups include without limitation, cyclopropyl groups, cyclopentyl groups, cyclohexyl groups, etc.
As used herein, the term "hydrocarbon" means a functional group containing exclusively hydrogen and carbon atoms. The functional group may be saturated (containing only single bonds) or unsaturated (containing double or triple bonds).
As used herein, the term "heterocycle" means cyclic compounds that have atoms of at least two different elements as members of its ring.
As used herein, the abbreviation "Me" refers to a methyl group; the abbreviation "Et" refers to an ethyl group; the abbreviation "Pr" refers to any propyl group (i.e., n-propyl or isopropyl); the abbreviation "iPr" refers to an isopropyl group; the abbreviation "Bu" refers to any butyl group (n-butyl, iso-butyl, t-butyl, sec-butyl); the abbreviation "tBu" refers to a tert-butyl group; the abbreviation "sBu" refers to a sec-butyl group; the abbreviation "iBu" refers to an iso-butyl group; the abbreviation "Ph" refers to a phenyl group; the abbreviation "py" refers to a pyridine group; the abbreviation "THF" refers to tetrahydrofuran; and the abbreviation "Cp" refers to cyclopentadienyl group.

The standard abbreviations of the elements from the periodic table of elements are used herein. It should be understood that elements may be referred to by these abbreviations (e.g., Mn refers to manganese, Si refers to silicon, C refers to carbon, etc.)

Please note that the films or layers deposited, such as manganese oxide, are listed throughout the specification and claims without reference to their proper stoichoimetry. The layers may include pure (M) layers, silicide (MₒSiₚ) layers, carbide (MₒCₚ) layers, nitride (MₖNₗ) layers, oxide (MₙOₘ) layers, or mixtures thereof, wherein M is Mn; and k, l, m, n, o, and p inclusively range from 1 to 6. For instance, manganese silicide is MnₖSiₗ, where k and I each range from 0.5 to 5. Any referenced layers may also include a Silicon oxide layer, SiₙOₘ, wherein n ranges from 0.5 to 1.5 and m ranges from 1.5 to 3.5.. The silicon oxide layer may be a silicon oxide based dielectric material, such as a carbon-doped silicon oxide based low-k dielectric materials such as the Black Diamond II or III material by Applied Materials, Inc. Alternatively, any referenced silicon-containing layer may be pure silicon. Any silicon-containing layers may also include dopants, such as B, C, P, As and/or Ge.

### Brief Description of the Drawings

For a further understanding of the nature and objects of the present invention, reference should be made to the following detailed description, taken in conjunction with the accompanying drawings, in which like elements are given the same or analogous reference numbers and wherein:
**FIG. 1** is a side cross-section view of one embodiment of the Mn-containing film forming composition delivery device **1**;
**FIG. 2** is a side cross-section view of a second embodiment of the Mn-containing film forming composition delivery device **1**;
**FIG. 3** is a side cross-section view of an exemplary embodiment of a solid precursor sublimator **100** for subliming solid Mn-containing film forming compositions;
**FIG. 4** is a comparative open cup Thermogravimetric Analysis (TGA) graph, under 1010 mbar, demonstrating the percentage of weight loss with increasing temperature of {Mn[N(SiMe₃)₂]₂}₂, {Mn[N(SiMe₂Et)₂]₂}₂, {Mn[N(SiMe₃)(tBu)₂]₂}₂, and {Mn[N(SiMe₂nBu)₂]₂}₂;
**FIG. 5** is a TGA graph demonstrating the percentage of weight loss with increasing temperature of {Mn[N(SiMe₂Et)₂]₂}₂ before and after 1 and 2 weeks and 1, 2, and 3 months of stability testing at 120°C;
**FIG. 6** is a TGA graph demonstrating the percentage of weight loss with increasing temperature of {Mn[N(SiMe₃)(tBu)]₂}₂ before and after 1 and 2 weeks of stability testing at 90°C;
**FIG. 7** is a TGA graph demonstrating the percentage of weight loss with increasing temperature of {Mn[N(SiMe₃)₂]₂}₂ before and after 8 weeks and 3 months of stability testing at 70°C; and
**FIG. 8** is a TGA graph demonstrating the percentage of weight loss with increasing temperature of {Mn[N(SiMe₃)₂]₂}₂ before and after 2 and 4 weeks and 2 and 3 months of stability testing at 90°C.

### Description of Preferred Embodiments

According to the invention the Mn-containing film forming compositions comprises a silylamide-containing precursor selected from {Mn[N(SiMe₂Et)₂]₂}₂ or Mn[N(SiMe₃)₂]₂NMeEt₂). Disclosed are also Mn-containing film forming compositions comprising silylamide-containing precursors having the following formula: 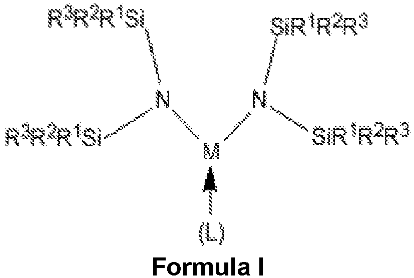 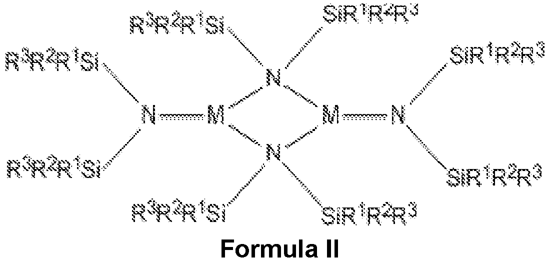 wherein M is Mn; each R¹, R² and R³ is independently selected from hydrogen (H) or a C1-C4 hydrocarbon; L is one or two neutral adducts selected from pyridine, NMe₃, NEt₃, NMe₂Et, NMeEt₂, 1-Me-pyrrolidine, or PMe₃; and R¹ and R² or R² and R³ may be joined to form a cyclic silicon-containing heterocycle. Each R¹, R² and R³ is preferably independently H, methyl, ethyl, isopropyl, n-propyl, n-butyl, or t-butyl.

Exemplary silylamide containing precursors having Formula I include Mn[N(SiMe₃)₂]₂(py); Mn[N(SiMe₃)₂]₂(Me₃N); Mn[N(SiMe₃)₂]₂(Et₃N); Mn[N(SiMe₃)₂]₂(Me₂EtN); Mn[N(SiMe₃)₂]₂(MeEt₂N); Mn[N(SiMe₃)₂]₂(1-Me-pyrrolidine); Mn[N(SiMe₃)₂]₂(PMe₃); Mn[N(SiMe₂Et)₂]₂(py); Mn[N(SiMe₂Et)₂]₂(Me₃N); Mn[N(SiMe₂Et)₂]₂(Et₃N); Mn[N(SiMe₂Et)₂]₂(Me₂EtN); Mn[N(SiMe₂Et)₂]₂(MeEt₂N); Mn[N(SiMe₂Et)₂]₂(1-Me-pyrrolidine); Mn[N(SiMe₂Et)₂]₂(PMe₃), and combinations thereof. thereof, wherein according to the invention the silylamide containing precursor is Mn[N(SiMe₃)₂]₂NMeEt₂).

Exemplary silylamide containing precursors having Formula II include {Mn[N(SiMe₃)₂]₂}₂; {Mn[N(SiMe₂Et)₂]₂}₂; {Mn[N(SiMeEt₂)₂]₂}₂; {Mn[N(SiMe₂H)₂]₂}₂; {Mn[N(SiMe₃)(tBu)]₂}₂; {Mn[N(SiMe₂nBu)₂]₂}₂; and combinations thereof. Preferably, the exemplary silylamide containing precursor having Formula II are {Mn[N(SiMe₂Et)₂]₂}₂; {Mn[N(SiMeEt₂)₂]₂}₂; {Mn[N(SiMe₂H)₂]₂}₂; {Mn[N(SiMe₃)(tBu)]₂}₂; {Mn[N(SiMe₂nBu)₂]₂}₂; and combinations thereof, and according to the invention {Mn[N(SiMe₂Et)₂]₂}₂.

The silylamide-containing precursors may be synthesized by reacting MnX₂, wherein X is Cl, Br, or I, with M(N(SiR¹R²R³)₂), wherein M is Li, Na, or K, in a solvent, such as tetrahydrofuran (THF), ether, pentane, cyclohexane, hexane, heptane, or toluene. The solvent may be removed and the product of Formula I or II isolated from the salt byproduct using filtration and/or sublimation. The L=THF adduct of Formula I may be substituted by adding the protonated form of the desired ligand to an alkane solution, such as pentane, heptane, hexane, or cyclohexane, of the THF-containing precursor and extracting the product. Further details are provided in the examples that follow.

To ensure process reliability, the disclosed Mn-containing film forming compositions may be purified by continuous or fractional batch distillation, recrystallization, or sublimation prior to use to a purity ranging from approximately 95% w/w to approximately 100% w/w, preferably ranging from approximately 98% w/w to approximately 100% w/w. The Mn-containing film forming composition consists essentially of the silylamide-containing precursor when the purity ranges from approximately 99% w/w to approximately 100% w/w. One of ordinary skill in the art will recognize that the purity may be determined by H NMR or gas or liquid chromatography with mass spectrometry. The Mn-containing film forming compositions may contain any of the following impurities: halides, alkali metals, alkyl amines, alkylamino-substituted silanes, pyridine, 1-methylpyrrolidine, pyrrolidine, THF, ether, pentane, cyclohexane, heptane, toluene, halogenated metal compounds. Preferably, the total quantity of these impurities is below 0.1% w/w. The purified composition may be produced by recrystallization, sublimation, distillation, and/or passing the gas or liquid through a suitable adsorbent, such as a 4Å molecular sieve.

The concentration of each solvent, such as THF, ether, pentane, cyclohexane, heptanes, and/or toluene, in the purified Mn-containing film forming compositions may range from approximately 0% w/w to approximately 5% w/w, preferably from approximately 0% w/w to approximately 0.1% w/w. Solvents may be used in the Mn-containing film forming composition's synthesis. Separation of the solvents from the composition may be difficult if both have similar boiling points. Cooling the mixture may produce solid precursor in liquid solvent, which may be separated by filtration. Vacuum distillation may also be used, provided the composition is not heated above approximately its decomposition point.

The disclosed Mn-containing film forming composition contains less than 5% v/v, preferably less than 1% v/v, more preferably less than 0.1% v/v, and even more preferably less than 0.01% v/v of any of its analogs or other reaction products. This embodiment may provide better process repeatability. This embodiment may be produced by distillation of the Mn-containing film forming composition.

Alternatively, the disclosed Mn-containing film forming compositions may comprise between approximately 5% w/w to approximately 50% w/w of one compound with the balance of the composition comprising a second compound, particularly when the mixture provides improved process parameters or isolation of the target compound is too difficult or expensive. For example, the disclosed Mn-containing film forming compositions may be 40/60% w/w of Mn[N(SiMe₃)₂]₂(NMe₂Et) and Mn[N(SiMe₃)₂]₂(NMeEt₂). The mixture may produce a stable, liquid composition suitable for vapor deposition.

The concentration of trace metals and metalloids in the purified Mn-containing film forming composition may each range independently from approximately 0 ppbw to approximately 100 ppbw, and more preferably from approximately 0 ppbw to approximately 10 ppbw. These metal or metalloid impurities include, but are not limited to, Aluminum(AI), Arsenic(As), Barium(Ba), Beryllium(Be), Bismuth(Bi), Cadmium(Cd), Calcium(Ca), Chromium(Cr), Cobalt (Co), Copper(Cu), Gallium(Ga), Germanium(Ge), Hafnium(Hf), Zirconium(Zr), Indium(In), Iron(Fe), Lead(Pb), Lithium(Li), Magnesium(Mg), Tungsten(W), Nickel(Ni), Potassium(K), Sodium(Na), Strontium(Sr), Thorium(Th), Tin(Sn), Titanium(Ti), Uranium(U), Vanadium(V) and Zinc(Zn). The concentration of X (where X = Cl, Br) in the purified Mn-containing film forming composition may range between approximately 0 ppmw and approximately 100 ppmw and more preferably between approximately 0 ppmw to approximately 10 ppmw.

Care should be taken to prevent exposure of the disclosed Mn-containing film forming compositions to water as this may result in decomposition of the silylamine-containing precursors.

Also disclosed are methods of using the disclosed Mn-containing film forming compositions for vapor deposition methods. The disclosed methods provide for the use of the Mn-containing film forming compositions for deposition of manganese-containing films. The disclosed methods may be useful in the manufacture of semiconductor, photovoltaic, LCD-TFT, flat panel type devices, refractory materials, or aeronautics.

The disclosed methods for forming a manganese-containing layer on a substrate include: placing a substrate in a reactor, delivering into the reactor a vapor of the disclosed Mn-containing film forming composition, and contacting the vapor with the substrate (and typically directing the vapor to the substrate) to form a manganese-containing layer on the surface of the substrate.

The methods may include forming a bimetal-containing layer on a substrate using the vapor deposition process and, more specifically, for deposition of MnMOₓ films wherein x is 4 and M is Ta, Hf, Nb, Mg, Al, Sr, Y, Ba, Ca, As, Sb, Bi, Sn, Pb, Co, lanthanides (such as Er), or combinations thereof. The disclosed methods may be useful in the manufacture of semiconductor, photovoltaic, LCD-TFT, or flat panel type devices. An oxygen source, such as O₃, O₂, H₂O, NO, H₂O₂, acetic acid, formalin, para-formaldehyde, oxygen radicals thereof, and combinations thereof, but preferably O₃ or plasma treated O₂, may also be introduced into the reactor.

The disclosed Mn-containing film forming compositions may be used to deposit manganese-containing films using any deposition methods known to those of skill in the art. Examples of suitable deposition methods include chemical vapor deposition (CVD) or atomic layer deposition (ALD). Exemplary CVD methods include thermal CVD, pulsed CVD (PCVD), low pressure CVD (LPCVD), sub-atmospheric CVD (SACVD) or atmospheric pressure CVD (APCVD), hot-wire CVD (HWCVD, also known as cat-CVD, in which a hot wire serves as an energy source for the deposition process), radicals incorporated CVD, plasma enhanced CVD (PECVD) including but not limited to flowable PECVD, and combinations thereof. Exemplary ALD methods include thermal ALD, plasma enhanced ALD (PEALD), spatial isolation ALD, hot-wire ALD (HWALD), radicals incorporated ALD, and combinations thereof. Super critical fluid deposition may also be used. The deposition method is preferably ALD, PE-ALD, or spatial ALD in order to provide suitable step coverage and film thickness control.

The vapor of the Mn-containing film forming composition is generated and then introduced into a reaction chamber containing a substrate. The temperature and the pressure in the reaction chamber and the temperature of the substrate are held at conditions suitable for vapor deposition of at least part of the silylamine-containing precursor onto the substrate. In other words, after introduction of the vaporized composition into the reaction chamber, conditions within the reaction chamber are adjusted such that at least part of the precursor is deposited onto the substrate to form the Mn-containing layer. One of ordinary skill in the art will recognize that "at least part of the precursor is deposited" means that some or all of the precursor reacts with or adheres to the substrate. Herein, a reactant may also be used to help in formation of the Mn-containing layer.

The reaction chamber may be any enclosure or chamber of a device in which deposition methods take place, such as, without limitation, a parallel-plate type reactor, a cold-wall type reactor, a hot-wall type reactor, a single-wafer reactor, a multi-wafer reactor, or other such types of deposition systems. All of these exemplary reaction chambers are capable of serving as an ALD or CVD reaction chamber. The reaction chamber may be maintained at a pressure ranging from about 0.5mTorr to about 20Torr for all ALD and subatmospheric CVD. Subatmospheric CVD and atmospheric CVD pressures may range up to 760Torr (atmosphere). In addition, the temperature within the reaction chamber may range from about 20°C to about 600°C. One of ordinary skill in the art will recognize that the temperature may be optimized through mere experimentation to achieve the desired result.

The temperature of the reactor may be controlled by either controlling the temperature of the substrate holder or controlling the temperature of the reactor wall. Devices used to heat the substrate are known in the art. The reactor wall is heated to a sufficient temperature to obtain the desired film at a sufficient growth rate and with desired physical state and composition. A non-limiting exemplary temperature range to which the reactor wall may be heated includes from approximately 20°C to approximately 600°C. When a plasma deposition process is utilized, the deposition temperature may range from approximately 20°C to approximately 550°C. Alternatively, when a thermal process is performed, the deposition temperature may range from approximately 300°C to approximately 600°C.

Alternatively, the substrate may be heated to a sufficient temperature to obtain the desired manganese-containing film at a sufficient growth rate and with desired physical state and composition. A non-limiting exemplary temperature range to which the substrate may be heated includes from 150°C to 600°C. Preferably, the temperature of the substrate remains less than or equal to 500°C.

The reactor contains one or more substrates onto which the films will be deposited. A substrate is generally defined as the material on which a process is conducted. The substrates may be any suitable substrate used in semiconductor, photovoltaic, flat panel, or LCD-TFT device manufacturing. Examples of suitable substrates include wafers, such as silicon, silica, glass, or GaAs wafers. The wafer may have one or more layers of differing materials deposited on it from a previous manufacturing step. For example, the wafers may include silicon layers (crystalline, amorphous, porous, *etc.*), silicon oxide layers, silicon nitride layers, silicon oxy nitride layers, carbon doped silicon oxide (SiCOH) layers, or combinations thereof. Additionally, the wafers may include copper layers or noble metal layers (e.g. platinum, palladium, rhodium, or gold). The layers may include oxides which are used as dielectric materials in MIM, DRAM, or FeRam technologies (e.g., ZrO₂ based materials, HfO₂ based materials, TiO₂ based materials, rare earth oxide based materials, ternary oxide based materials such as strontium ruthenium oxide [SRO], *etc.*) or from nitride-based films (e.g., TaN) that are used as an oxygen barrier between copper and the low-k layer. The wafers may include barrier layers, such as manganese, manganese oxide, *etc.* Plastic layers, such as poly(3,4-ethylenedioxythiophene)poly (styrenesulfonate) [PEDOT:PSS] may also be used. The layers may be planar or patterned. For example, the layer may be a patterned photoresist film made of hydrogenated carbon, for example CHₓ, wherein x is greater than zero.

The disclosed processes may deposit the manganese-containing layer directly on the wafer or directly on one or more than one (when patterned layers form the substrate) of the layers on top of the wafer. The substrate may be patterned to include vias or trenches having high aspect ratios. For example, a conformal Mn-containing film, such as manganese oxide, may be deposited using any ALD technique on the holes or trenches of a thin film solid state battery having an aspect ratio ranging from approximately 20:1 to approximately 100:1. Furthermore, one of ordinary skill in the art will recognize that the terms "film" or "layer" used herein refer to a thickness of some material laid on or spread over a surface and that the surface may be a trench or a line. Throughout the specification and claims, the wafer and any associated layers thereon are referred to as substrates. In many instances though, the preferred substrate utilized may be selected from carbon-doped oxide, TaN, Ta, TiN, Cu, Ru, and Si type substrates, such as polysilicon or crystalline silicon substrates.

The disclosed Mn-containing film forming compositions may further comprise a solvent, such as toluene, ethyl benzene, xylene, mesitylene, decane, dodecane, octane, hexane, pentane, tertiary amines, acetone, tetrahydrofuran, ethanol, ethylmethylketone, 1,4-dioxane, or others. The disclosed compositions may be present in varying concentrations in the solvent. For example, the resulting concentration may range from approximately 0.05M to approximately 2M.

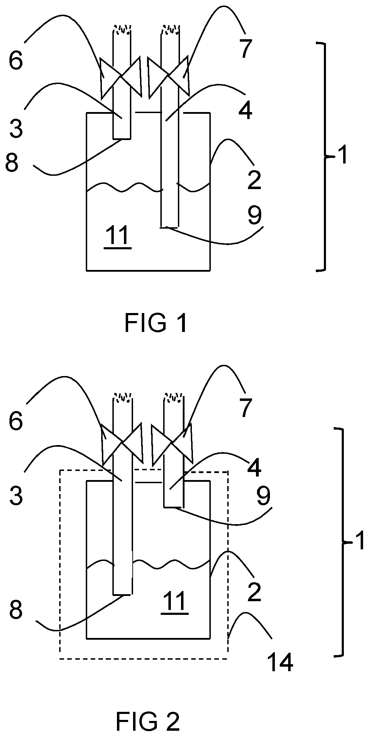

The Mn-containing film forming compositions may be delivered to the reactor by the Mn-containing film forming composition delivery devices of **FIGS 1-****3,** which show three exemplary embodiments of Mn-containing film forming composition delivery devices.

**FIG 1** is a side view of one embodiment of the Mn-containing film forming composition reactant delivery device **1.** In **FIG 1****,** the disclosed Mn-containing film forming compositions **11** are contained within a container **2** having two conduits, an inlet conduit **3** and an outlet conduit **4.** One of ordinary skill in the reactant art will recognize that the container **2,** inlet conduit **3,** and outlet conduit **4** are manufactured to prevent the escape of the gaseous form of the Mn-containing film forming composition **11,** even at elevated temperature and pressure.

The outlet conduit **4** of the delivery device **1** fluidly connects to the reactor (not shown) or other components between the delivery device and the reactor, such as a gas cabinet, via valve **7.** Preferably, the container **2,** inlet conduit **3,** valve **6,** outlet conduit **4,** and valve **7** are made of 316L EP or 304 stainless steel. However, one of ordinary skill in the art will recognize that other non-reactive materials may also be used in the teachings herein.

In **FIG 1**, the end **8** of inlet conduit **3** is located above the surface of the Mn-containing film forming composition **11**, whereas the end **9** of the outlet conduit **4** is located below the surface of the Mn-containing film forming composition **11**. In this embodiment, the Mn-containing film forming composition **11** is preferably in liquid form. An inert gas, including but not limited to nitrogen, argon, helium, and mixtures thereof, may be introduced into the inlet conduit **3.** The inert gas pressurizes the delivery device **2** so that the liquid Mn-containing film forming composition **11** is forced through the outlet conduit **4** and to the reactor (not shown). The reactor may include a vaporizer which transforms the liquid Mn-containing film forming composition **11** into a vapor, with or without the use of a carrier gas such as helium, argon, nitrogen or mixtures thereof, in order to deliver the vapor to the substrate on which the film will be formed. Alternatively, the liquid Mn-containing film forming composition **10** may be delivered directly to the wafer surface as a jet or aerosol.

**FIG 2** is a side view of a second embodiment of the Mn-containing film forming composition delivery device **1**. In **FIG 2**, the end **8** of inlet conduit **3** is located below the surface of the Mn-containing film forming composition **11**, whereas the end **9** of the outlet conduit **4** is located above the surface of the Mn-containing film forming composition **11.** **FIG 2** also includes an optional heating element **14**, which may increase the temperature of the Mn-containing film forming composition **11**. In this embodiment, the Mn-containing film forming composition **11** may be in solid or liquid form. An inert gas, including but not limited to nitrogen, argon, helium, and mixtures thereof, is introduced into the inlet conduit **3**. The inert gas bubbles through the Mn-containing film forming composition **11** and carries a mixture of the inert gas and vaporized Mn-containing film forming composition **11** to the outlet conduit **4** and on to the reactor. Bubbling with the carrier gas may also remove any dissolved oxygen present in the Mn-containing film forming composition.

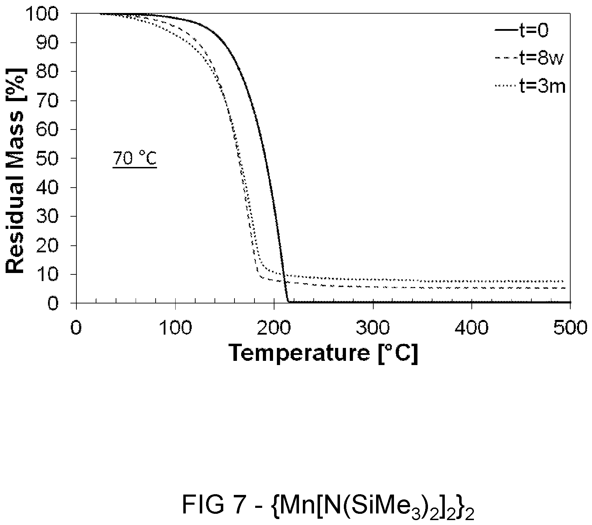

**FIGS 1 and 2** include valves **6** and **7**. One of ordinary skill in the art will recognize that valves **6** and **7** may be placed in an open or closed position to allow flow through conduits **3** and **4**, respectively. Either delivery device **1** in **FIGS 1 and 2**, or a simpler delivery device having a single conduit terminating above the surface of any solid or liquid present, may be used if the Mn-containing film forming composition **11** is in vapor form or if sufficient vapor pressure is present above the solid/liquid phase. In this case, the Mn-containing film forming composition **11** is delivered in vapor form through the conduit **3** or **4** simply by opening the valve **6** in **FIG 1** or **7** in **FIG 2****.** The delivery device **1** may be maintained at a suitable temperature to provide sufficient vapor pressure for the Mn-containing film forming composition **11** to be delivered in vapor form, for example by the use of an optional heating element **14**.

While **FIGS 1 and 2** disclose two embodiments of the Mn-containing film forming composition delivery device **1**, one of ordinary skill in the art will recognize that the inlet conduit **3** and outlet conduit **4** may also both be located above or below the surface of the Mn-containing film forming composition **11** without departing from the disclosure herein. Furthermore, inlet conduit **3** may be a filling port.

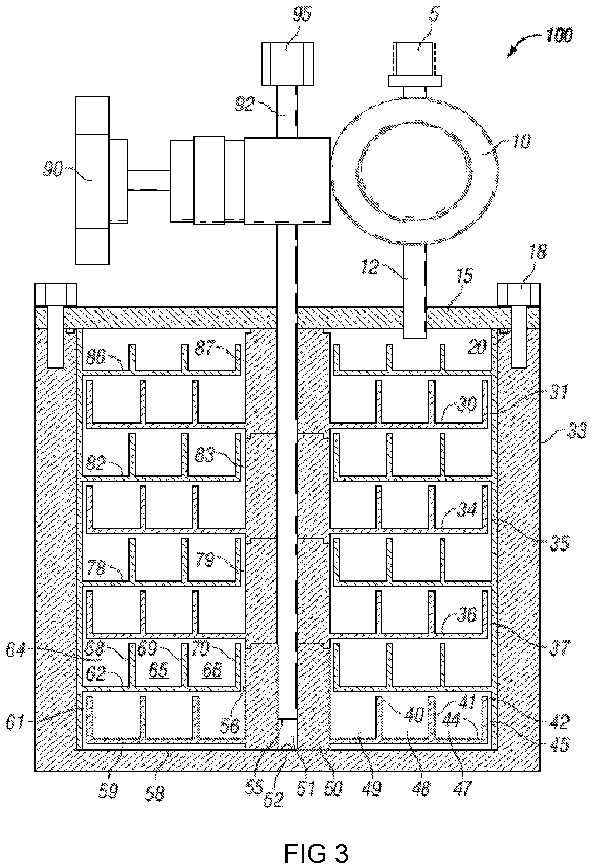

The vapors of solid forms of the Mn-containing film forming compositions may be delivered to the reactor using a sublimator. **FIG 3** shows one embodiment of an exemplary sublimator **100**. The sublimator **100** comprises a container **33**. Container **33** may be a cylindrical container, or alternatively, may be any shape, without limitation. The container **33** is constructed of materials such as stainless steel, nickel and its alloys, quartz, glass, and other chemically compatible materials, without limitation. In certain instances, the container **33** is constructed of another metal or metal alloy, without limitation. In certain instances, the container **33** has an internal diameter from about 8 centimeters to about 55 centimeters and, alternatively, an internal diameter from about 8 centimeters to about 30 centimeters. As understood by one skilled in the art, alternate configurations may have different dimensions.

Container **33** comprises a sealable top **15**, sealing member **18**, and gasket **20**. Sealable top **15** is configured to seal container **33** from the outer environment. Sealable top **15** is configured to allow access to the container **33**. Additionally, sealable top **15** is configured for passage of conduits into container **33**. Alternatively, sealable top **15** is configured to permit fluid flow into container **33**. Sealable top **15** is configured to receive and pass through a conduit comprising a dip tube **92** to remain in fluid contact with container **33**. Dip tube **92** having a control valve **90** and a fitting **95** is configured for flowing carrier gas into container **33**. In certain instances, dip tube **92** extends down the center axis of container **33**. Further, sealable top **15** is configured to receive and pass through a conduit comprising outlet tube **12**. The carrier gas and vapor of the Mn-containing film forming composition is removed from container **33** through the outlet tube **12**. Outlet tube **12** comprises a control valve **10** and fitting **5**. In certain instances, outlet tube **12** is fluidly coupled to a gas delivery manifold, for conducting carrier gas from the sublimator **100** to the reactor.

Container **33** and sealable top **15** are sealed by at least two sealing members **18**; alternatively, by at least about four sealing members. In certain instance, sealable top **15** is sealed to container **33** by at least about eight sealing members **18**. As understood by one skilled in the art, sealing member **18** releasably couples sealable top **15** to container **33**, and forms a gas resistant seal with gasket **20**. Sealing member **18** may comprise any suitable means known to one skilled in the art for sealing container **33**. In certain instances, sealing member **18** comprises a thumbscrew.

As illustrated in **FIG 3**, container **33** further comprises at least one disk disposed therein. The disk comprises a shelf, or horizontal support, for solid material. In certain embodiments, an interior disk **30** is disposed annularly within the container **33**, such that the disk **30** includes an outer diameter or circumference that is less than the inner diameter or circumference of the container **33**, forming an opening **31**. An exterior disk **86** is disposed circumferentially within the container **33**, such that the disk **86** comprises an outer diameter or circumference that is the same, about the same, or generally coincides with the inner diameter of the container **33**. Exterior disk **86** forms an opening **87** disposed at the center of the disk. A plurality of disks is disposed within container **33**. The disks are stacked in an alternating fashion, wherein interior disks **30, 34, 36, 44** are vertically stacked within the container with alternating exterior disks **62, 78, 82, 86.** In embodiments, interior disks **30, 34, 36, 44** extend annularly outward, and exterior disks **62, 78, 82, 86** extend annularly toward the center of container **33**. As illustrated in the embodiment of **FIG 3****,** interior disks **30, 34, 36, 44** are not in physical contact with exterior disks **62, 78, 82, 86**

The assembled sublimator **100** comprises interior disks **30, 34, 36, 44** comprising aligned and coupled support legs **50,** interior passage **51,** concentric walls **40, 41, 42,** and concentric slots **47, 48, 49.** The interior disks **30, 34, 36, 44** are vertically stacked, and annularly oriented about the dip tube **92**. Additionally, the sublimator comprises exterior disks **62, 78, 82, 86.** As illustrated in **FIG 3****,** the exterior disks **62, 78, 82, 86** should be tightly fit into the container **33** for a good contact for conducting heat from the container **33** to the disks **62, 78, 82, 86.** Preferably, the exterior disks **62, 78, 82, 86** are coupled to, or in physical contact with, the inner wall of the container **33.**

As illustrated, exterior disks **62, 78, 82, 86** and interior disks **30, 34, 36, 44** are stacked inside the container **33.** When assembled in container **33** to form sublimator **100,** the interior disks **30, 34, 36, 44** form outer gas passages **31, 35, 37, 45** between the assembled exterior disks **62, 78, 82, 86.** Further, exterior disks **62, 78, 82, 86** form inner gas passages **56, 79, 83, 87** with the support legs of the interior disks **30, 34, 36, 44.** The walls **40, 41, 42** of interior disks **30, 34, 36, 44** form the grooved slots for holding solid precursors. Exterior disks **62, 78, 82, 86** comprise walls **68, 69, 70** for holding solid precursors. During assembly, the solid precursors are loaded into the annular slots **47, 48, 49** of interior disks **30, 34, 36, 44** and annular slots **64, 65, 66** of exterior disks **62, 78, 82, 86.**

Solid powders and/or granular particles of sizes less than about 1 centimeter, alternatively less than about 0.5 centimeter, and alternatively less than about 0.1 centimeter are loaded into the annular slots **47, 48, 49** of interior disks **30, 34, 36, 44** and annular slots **64, 65, 66** of exterior disks **62, 78, 82, 86.** The solid precursors are loaded into the annular slots of each disk by any method suitable for uniform distribution of solid in the annular slots. Suitable methods include direct pour, using a scoop, using a funnel, automated measured delivery, and pressurized delivery, without limitation. Depending on the chemical properties of the solid precursor materials, loading may be conducted in a sealed environment. Additionally, inert gas atmosphere and/or pressurization in a sealed box may be implemented for those toxic, volatile, oxidizable, and/or air sensitive solids. Each disk could be loaded after setting the disk in the container **33.** A more preferred procedure is to load the solid prior to setting the disk into container **33.** The total weight of solid precursor loaded into the sublimator may be recorded by weighing the sublimator before and after loading process. Further, consumed solid precursor may be calculated by weighing the sublimator after the vaporization and deposition process.

Dip tube **92,** having the control valve **90** and the fitting **95,** is positioned in the center passage **51** of the aligned and coupled support legs of the interior disks **30, 34, 36, 44.** Thus, dip tube **92** passes through interior passage **51** vertically toward bottom **58** of container **33.** The dip tube end **55** is disposed proximal to the bottom **58** of container at/or above the gas windows **52.** Gas windows **52** are disposed in bottom interior disk **44.** The gas windows **52** are configured to allow carrier gas flow out of the dip tube **92.** In the assembled sublimator **100,** a gas passageway **59** is formed by the bottom surface **58** of the container **33,** and the bottom interior disk **44.** In certain instances, gas passageway **59** is configured to heat carrier gas.

In operation, the carrier gas is preheated prior to introduction into the container **33** via dip tube **92.** Alternatively, the carrier gas can be heated while it flows through the gas passageway **59** by the bottom surface **58.** Bottom surface **58** is thermally coupled and/or heated by an external heater consistently with the teachings herein. The carrier gas then passes through the gas passageway **45** that is formed by the outer wall **42** of the interior disk **44** and the outside wall **61** of the exterior disk **62.** The gas passageway **45** leads to the top of the interior disk **44.** The carrier gas continuously flows over the top of the solid precursors loaded into the annular slots **47, 48,** and **49.** Sublimed solid vapor from annular slots **47, 48, 49** is mixed with carrier gas and is flowed vertically upward through container **33**.

While **FIG 3** discloses one embodiment of a sublimator capable of delivering the vapor of any solid Mn-containing film forming composition to the reactor, one of ordinary skill in the art will recognize that other sublimator designs may also be suitable, without departing from the teachings herein. Finally, one of ordinary skill in the art will recognize that the disclosed Mn-containing film forming composition may be delivered to semiconductor processing tools using other delivery devices, such as the ampoules disclosed in WO 2006/059187 to Jurcik et al., without departing from the teachings herein.

If necessary, the Mn-containing film forming composition devices of **FIGS 1-3** may be heated to a temperature that permits the Mn-containing film forming composition to be in its liquid phase and to have a sufficient vapor pressure. The delivery device may be maintained at temperatures in the range of, for example, 0-150°C. Those skilled in the art recognize that the temperature of the delivery device may be adjusted in a known manner to control the amount of Mn-containing film forming composition vaporized.

In addition to the disclosed precursor, a reactant may also be introduced into the reactor. The reactant may contain oxygen, such as one of O₂, O₃, H₂O, H₂O₂; oxygen containing radicals, such as O^{.} or OH^{.}, NO, NO₂; carboxylic acids such as formic acid, acetic acid, propionic acid, radical species of NO, NO₂, or the carboxylic acids; para-formaldehyde; and mixtures thereof. Preferably, the oxygen-containing reactant is selected from the group consisting of O₂, O₃, H₂O, H₂O₂, oxygen containing radicals thereof such as O^{.} or OH^{.}, and mixtures thereof. Preferably, when an ALD process is performed, the reactant is plasma treated oxygen, ozone, or combinations thereof. When an oxygen-containing reactant is used, the resulting manganese containing film will also contain oxygen.

Alternatively, the reactant may be one of H₂, NH₃, (SiH₃)₃N, hydridosilanes (for example, SiH₄, Si₂H₆, Si₃H₈, Si₄H₁₀, Si₅H₁₀, Si₆H₁₂), chlorosilanes and chloropolysilanes (for example, SiHCl₃, SiH₂Cl₂, SIH₃Cl, Si₂Cl₆, Si₂HCl₅, Si₃Cl₈), alkylsilanes (for example, (CH₃)₂SiH₂, (C₂H₅)₂SiH₂, (CH₃)SiH₃, (C₂H₅)SiH₃), hydrazines (for example, N₂H₄, MeHNNH₂, MeHNNHMe), organic amines (for example, N(CH₃)H₂, N(C₂H₅)H₂, N(CH₃)₂H, N(C₂H₅)₂H, N(CH₃)₃, N(C₂H₅)₃, (SiMe₃)₂NH), pyrazoline, pyridine, B-containing molecules (for example, B₂H₆, 9-borabicyclo[3,3,1]none, trimethylboron, triethylboron, borazine), alkyl metals (such as trimethylaluminum, triethylaluminum, dimethylzinc, diethylzinc), radical species thereof, and mixtures thereof. Preferably, the reactant is H₂, NH₃, SiH₄, Si₂H₆, Si₃H₈, SiH₂Me₂, SiH₂Et₂, N(SiH₃)₃, hydrogen radicals thereof, or mixtures thereof. Preferably, the reactant is SiHCl₃, Si₂Cl₆, Si₂HCl₅, Si₂H₂Cl₄, and cyclo-Si₆H₆Cl₆. When these reactants are used, the resulting Mn-containing film may be pure Mn.

The reactant may be treated by plasma, in order to decompose the reactant into its radical form. N₂ may also be utilized as a reactant when treated with plasma. For instance, the plasma may be generated with a power ranging from about 50W to about 500W, preferably from about 100W to about 200W. The plasma may be generated or present within the reactor itself. Alternatively, the plasma may generally be at a location removed from the reactor, for instance, in a remotely located plasma system. One of skill in the art will recognize methods and apparatus suitable for such plasma treatment.

When the desired Mn-containing film also contains another element, such as, for example and without limitation, Ta, Hf, Nb, Mg, Al, Sr, Y, Ba, Ca, As, Sb, Bi, Sn, Pb, Co, lanthanides (such as Er), or combinations thereof, the reactants may include a another precursor which is selected from, but not limited to, alkyls, such as Ln(RCp)₃, amines, such as Nb(Cp)(NtBu)(NMe₂)₃ or any combination thereof.

The Mn-containing film forming composition and one or more reactants may be introduced into the reaction chamber simultaneously (*e.g*., CVD), sequentially (*e.g*., ALD), or in other combinations. For example, the Mn-containing film forming composition may be introduced in one pulse and two additional reactants may be introduced together in a separate pulse (*e.g*., modified ALD). Alternatively, the reaction chamber may already contain the reactant prior to introduction of the Mn-containing film forming composition. The reactant may be passed through a plasma system localized or remotely from the reaction chamber, and decomposed to radicals. Alternatively, the Mn-containing film forming composition may be introduced to the reaction chamber continuously while other reactants are introduced by pulse (*e.g.*, pulsed-CVD). In each example, a pulse may be followed by a purge or evacuation step to remove excess amounts of the component introduced. In each example, the pulse may last for a time period ranging from about 0.01s to about 10s, alternatively from about 0.3s to about 3s, alternatively from about 0.5s to about 2s. In another alternative, the Mn-containing film forming composition and one or more reactants may be simultaneously sprayed from a shower head under which a susceptor holding several wafers is spun (*e.g*., spatial ALD).

In one non-limiting exemplary ALD type process, the vapor phase of a Mn-containing film forming composition is introduced into the reaction chamber, where at least part of the silylamine-containing precursor reacts with a suitable substrate, such as Si, SiO₂, Al₂O₃, *etc.,* to form an adsorbed manganese layer. Excess composition may then be removed from the reaction chamber by purging and/or evacuating the reaction chamber. An oxygen source is introduced into the reaction chamber where it reacts with the absorbed manganese layer in a self-limiting manner. Any excess oxygen source is removed from the reaction chamber by purging and/or evacuating the reaction chamber. If the desired film is a manganese oxide film, this two-step process may provide the desired film thickness or may be repeated until a film having the necessary thickness has been obtained.

Alternatively, if the desired film contains a second element (i.e., MnMOₓ, wherein x may be 1-4 and M is Si, Ta, Hf, Nb, Mg, Al, Sr, Y, Ba, Ca, As, Sb, Bi, Sn, Pb, Co, lanthanides (such as Er), or combinations thereof), the two-step process above may be followed by introduction of a vapor of a second precursor into the reaction chamber. The second precursor will be selected based on the nature of the oxide film being deposited. After introduction into the reaction chamber, the second precursor is contacted with the substrate. Any excess second precursor is removed from the reaction chamber by purging and/or evacuating the reaction chamber. Once again, an oxygen source may be introduced into the reaction chamber to react with the second precursor. Excess oxygen source is removed from the reaction chamber by purging and/or evacuating the reaction chamber. If a desired film thickness has been achieved, the process may be terminated. However, if a thicker film is desired, the entire four-step process may be repeated. By alternating the provision of the Mn-containing film forming composition, second precursor, and oxygen source, a film of desired composition and thickness can be deposited.

Additionally, by varying the number of pulses, films having a desired stoichiometric M:Mn ratio may be obtained. For example, a MnSiO₂ film may be obtained by having one pulse of the Mn-containing film forming composition and one pulses of the second precursor, with each pulse being followed by pulses of the oxygen source. However, one of ordinary skill in the art will recognize that the number of pulses required to obtain the desired film may not be identical to the stoichiometric ratio of the resulting film.

In one non-limiting exemplary CVD type process, the vapor phase of a Mn-containing film forming composition, such as {Mn[N(SiMe₂Et)₂]₂}₂, is simultaneously introduced with a hydrogen (H₂) reactant into the reaction chamber containing a substrate. The substrate has a silicon-based insulating layer thereon, such as SiO₂, SiOC, porous SiOC, *etc.* A through-silicon via penetrates the silicon-based insulating layer, with the silicon-based insulating layer forming the sidewalls of the via and a metal line, such as copper, forming the bottom of the via. The via has an aspect ratio ranging from approximately 3:1 to approximately 20:1. Conditions within the reaction chamber are suitable to deposit a pure Mn layer on the silicon-based insulating layer, but not the metal line. If the temperature of the reaction chamber is suitable, the Mn layer diffuses into the silicon-containing substrate to form MnSiOₓC_{y}, wherein x and y each independently range from 1-3. If the temperature of the reaction chamber is not suitable, the substrate may be subject to further heating, such as annealing, to assist with the diffusion process.

In another exemplary ALD type process, the vapor phase of a Mn-containing film forming composition, such as {Mn[N(SiMe₂Et)₂]₂}₂, is introduced into the reaction chamber containing a substrate. The substrate has a silicon-based insulating layer thereon, such as SiO₂, SiOC, porous SiOC, *etc.* A through-silicon via penetrates the silicon-based insulating layer, with the silicon-based insulating layer forming the sidewalls of the via and a metal line, such as copper, forming the bottom of the via. The via has an aspect ratio ranging from approximately 3:1 to approximately 20:1. Conditions within the reaction chamber are suitable to deposit at least part of the silylamine-containing precursor on the substrate to form an adsorbed manganese layer. Excess composition may then be removed from the reaction chamber by purging and/or evacuating the reaction chamber. An reactant, such as H₂, is introduced into the reaction chamber where it reacts with the absorbed manganese layer in a self-limiting manner. Any excess reactant is removed from the reaction chamber by purging and/or evacuating the reaction chamber. If the temperature of the reaction chamber is suitable, the resulting Mn layer diffuses into the silicon-containing substrate to form MnSiOₓC_{y}, wherein x and y each independently range from 1-3. If the temperature of the reaction chamber is not suitable, the substrate may be subject to further heating, such as annealing, to assist with the diffusion process.

The manganese-containing films resulting from the processes discussed above may include Mn, MnSi₂, MnO₂, MnSiO₂, MnN, MnC, MnON, MnCN, MnCON, or MMnOₓ, wherein M is an element such as Hf, Zr, Ti, Nb, Ta, or Ge, and x may be from 0-4, depending on the oxidation state of M. One of ordinary skill in the art will recognize that by judicial selection of the appropriate Mn-containing film forming composition and reactants, the desired film composition may be obtained.

Upon obtaining a desired film thickness, the film may be subject to further processing, such as thermal annealing, furnace-annealing, rapid thermal annealing, UV or e-beam curing, and/or plasma gas exposure. Those skilled in the art recognize the systems and methods utilized to perform these additional processing steps. For example, the manganese-containing film may be exposed to a temperature ranging from approximately 200°C and approximately 1000°C for a time ranging from approximately 0.1 second to approximately 7200 seconds under an inert atmosphere, a H-containing atmosphere, a N-containing atmosphere, an O-containing atmosphere, or combinations thereof. Most preferably, the temperature is 600°C for less than 3600 seconds under an H-containing atmosphere. The resulting film may contain fewer impurities and therefore may have improved performance characteristics. The annealing step may be performed in the same reaction chamber in which the deposition process is performed. Alternatively, the substrate may be removed from the reaction chamber, with the annealing/flash annealing process being performed in a separate apparatus. Any of the above post-treatment methods, but especially thermal annealing, has been found effective to reduce carbon and nitrogen contamination of the manganese-containing film.

### Examples

The following non-limiting examples are provided to further illustrate embodiments of the invention. However, the examples are not intended to be all inclusive and are not intended to limit the scope of the inventions described herein.

### Example 1: General Synthesis of {Mn[N(SiR₃)₂]₂}₂

General procedure: A 3-neck round bottom was charged with hexamethyldisilazane (NH-(SiMe₃)₂) (2 equivalents). The setup was equipped with an addition funnel and a vacuum/gas adaptor and sealed with septa before bringing it onto a schlenkline (Ar). The hexamethyldisilazane with anhydrous THF was cooled to 0 °C. *n*-BuLi solution (2.5 M; 2eq.) was added to the THF solution slowly. The reaction mixture was allowed to stir for 30 minutes. A 2-neck round bottom is charged with MnCl₂ (1 eq.). This setup was equipped with a gas/vacuum adaptor before sealing it with septa and brought on the schlenkline (Ar). Anhydrous THF was transferred to the flask with MnCl₂ to form a suspension that was chilled to 0 °C. The above lithium amide solution was added to the MnCl₂ suspension which caused a color change to dark brown. The reaction mixture was allowed to react at room temperature for overnight. All volatiles were removed in *vacuo* before the crude mixture is worked up by filtration with pentane under inert atmosphere. And finally all volatiles are removed in *vacuo.*

{Mn[N(SiMe₃)₂]₂}₂ which is not according to the invention as claimed in the appended claims was purified by distillation under vacuum (300mTorr, 75°C) and pale pink oil was obtained and it solidified at RT. Melting point was 55°C.

{Mn[N(SiMe₂Et)₂]₂}₂: The distillation was performed under vacuum (30 mTorr; before heating), with a final oil bath temperature of 145 °C. The product was isolated as a pale pink oil. {Mn[N(SiMe₃)(tBu)]₂}₂ which is not according to the invention as claimed in the appended claims: The distillation was performed under vacuum (30 mTorr; before heating), with a final oil bath temperature of 120 °C. The product was isolated as a red liquid that solidified at RT. {Mn[N(SiMe₂nBu₂)]₂}₂ which is not according to the invention as claimed in the appended claims: Vacuum was applied at 30mTorr (prior to start of distillation). The high boiling brown oil was collected, while the low boiling fraction contained ligand.

{Mn[N(SiMe₃)₂]₂}₂ was characterized by XRD and elemental analysis. XRD: Single crystal was obtained from hexane at -30°C (see below). EA: C(Found 38.56/Calc 38.36), H(Found 9.79/ Calc 9.64), N (Found 7.52/ Calc 7.46).

### Example 2: Synthesis of {Mn[N(SiEtMe₂)₂]₂}₂

Under inert atmosphere, *n*-BuLi (2.5 M in hexanes; 31.7 mL; 0.0793 mol) was added slowly to a solution of 1,3-diethyl-1,1,3,3- tetramethyl-disilazane (15.0 g; 0.0791 mol) in THF (200 mL) at 0°C. The mixture was allowed to stir for 30 minutes at 22°C before chilling it back down to 0°C and slowly adding it via cannula to a suspension of MnCl₂ (4.98 g; 0.0396 mol) in THF (100 mL) at 0°C. The reaction mixture was stirred to at 22°C for overnight before removing all volatiles in *vacuo.* The resulting crude solid was taken up in pentane, decanted and filtered through Celite. All volatiles were removed in *vacuo* and residue was distilled to result in a pink oil (14.6 g; 0.0169 mol; 85% yield).

### Example 3: Synthesis of {Mn[N(SiMe₃)(t-Bu)]₂}₂ (not according to the invention as claimed in the appended claims)

Under inert atmosphere, *n*-BuLi (2.5 M in hexanes; 55.1 mL; 0.138 mol) was added slowly to a solution of N-tert-butyltrimethylsilylamine (20.0 g; 0.138 mol) in THF (200 mL) at 0°C. The mixture was allowed to stir for 30 minutes at 22°C before chilling it back down to 0°C and slowly adding it via cannula to a suspension of MnCl₂ (8.66 g; 0.0688 mol) in THF (100 mL) at 0°C. The reaction mixture was stirred to at 22°C for overnight before removing all volatiles in *vacuo.* The resulting crude product was taken up in pentane, decanted and filtered through Celite. All volatiles were removed in *vacuo* and residue was distilled to result in a red solid (6.37 g; 0.00927 mol; 27% yield).

### Example 4: Synthesis of {Mn[N(SiMe₂nBu)₂]₂}₂ (not according to the invention as claimed in the appended claims)

Under inert atmosphere, *n*-BuLi (2.5 M in hexanes; 49.0 mL; 0.112 mol) was added slowly to a solution of 1,3-di-*n*-butyl-1,1,3,3-tetramethyl- disilazane (30.0 g; 0.112 mol) in THF (200 mL) at 0°C. The mixture was allowed to stir for 30 minutes at 22°C before chilling it back down to 0°C and slowly adding it via cannula to a suspension of MnCl₂ (7.72 g; 0.0612 mol) in THF (100 mL) at 0 °C. The reaction mixture was stirred to at 22°C for overnight before removing all volatiles in *vacuo.* The resulting crude solid was taken up in pentane, decanted and filtered through Celite. All volatiles were removed in *vacuo* and residue was distilled to result in an oil (21.4 g; 0.0202 mol; 66% yield).

### Example 5: Thermal analysis

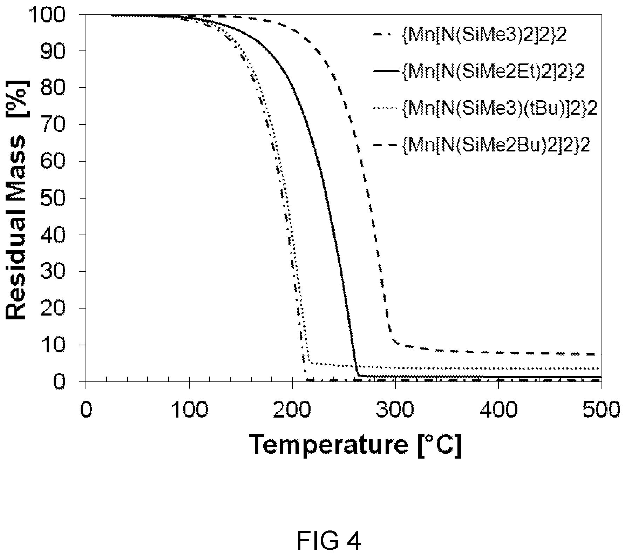

Volatility was monitored by TGA (ThermoGravimetric Analysis, METTLER, TGA/SDTA851) under nitrogen (220sccm). Temperature was increased by 10°C/min. Test sample was prepared under nitrogen in Aluminum pan. The results are shown in **FIG 4****.**

**FIG 4** is a comparative open cup TGA graph of the {Mn[N(SiR¹R²R³)₂]₂}₂ precursors with measurement under 1010 mbar. 1010 mbar is equivalent to atmospheric pressure or the pressure close to or at which the precursor may be stored.

As can be seen, the Mn[N(SiR¹R²R³)₂]₂ precursor family does not exhibit similar properties, notwithstanding the structural similarity of the precursors.

As for selection of precursor, volatility is important to be delivered to the reaction chamber. TGA data under atmospheric pressure tells which precursor is acceptable for use or not. Preferably, the precursor shows clear evaporation under vacuum.

### Example 6: Thermal stress test

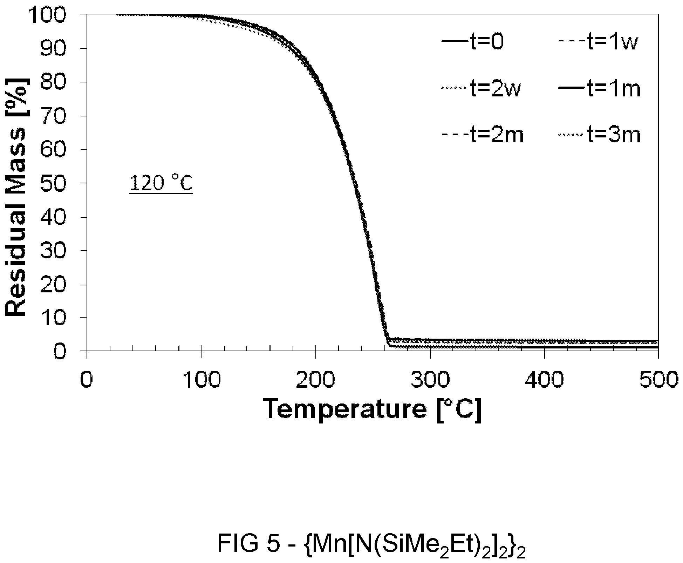

The samples were heated to varying temperatures for differing periods of times. TGA graphs showing any changes over specified periods of time to those samples that had been maintained at the specified temperatures are shown in **FIGS 5-8****.**

**FIG 5** shows the results for {Mn[N(SiMe₂Et)₂]₂}₂ samples prior to heating (line 0) and after heating to 120°C at 1 week, 2 weeks, 1 month, 2 months, and 3 months.

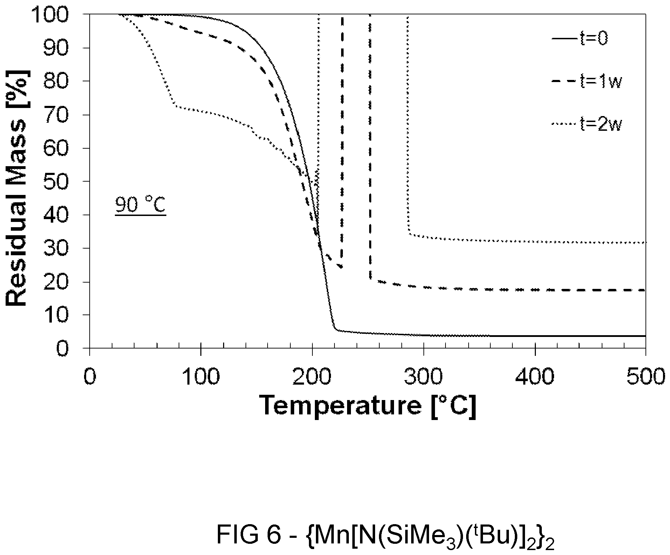

**FIG 6** shows the results for {Mn[N(SiMe₃)(tBu)]₂}₂ samples prior to heating (line 0) and after heating to 90°C at 1 week and 2 weeks. Significant decomposition is evidenced after 1 week by the increased residue and spike at approximately 250°C. The sample formed a mushroom-shaped residue during the TGA process. The spike at 250°C occurred just before the mushroom burst and rapidly released gas, causing a spike in weight followed by an immediate loss in weight.

**FIG 7** shows the results for {Mn[N(SiMe₃)₂]₂}₂ samples prior to heating (line 0) and after heating to 70°C at 8 weeks and 3 months.

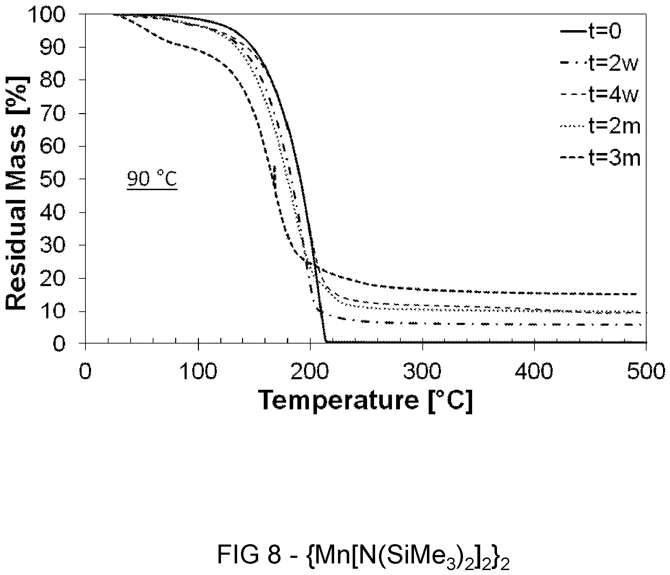

**FIG 8** shows the results for {Mn[N(SiMe₃)₂]₂}₂ samples prior to heating (line 0) and after heating to 90°C at 2 weeks, 4 weeks, 2 months, and 3 months. Both **FIGS 7** **and** **8** demonstrate that {Mn[N(SiMe₃)₂]₂}₂ exhibits decomposition at elevated temperatures. The left shift of the curves is the result of lower load sampling.

The stability of the precursor at usage temperature is also important. When a precursor is used, a canister is heated to give enough vapor, typically about 1 Torr. To make high growth rate, the canister may be heated more than 1 Torr temperature. Hence a precursor must to be stable without decomposition at elevated temperatures to keep sending expected vapor.

Materials that are utilized in the semiconductor industry with a low vapor pressure, such as these compounds, must remain stable at elevated temperatures. The canister may be kept at the elevated temperature for an extended duration that corresponds to the usage rate/productivity of the process tools (e.g., several weeks or several months). Materials that do not maintain their characteristics at such elevated temperatures may not be effectively utilized as precursors for semiconductor processing without additional exceptional equipment or conditioning. Applicants have surprisingly found that {Mn[N(SiMe₂Et)₂]₂}₂ has excellent thermal properties after extended high temperature exposure. Additionally, as the precursor contains no oxygen, it may be useful in the deposition of pure Mn films. It is also one of the few Mn-containing precursors in liquid form, making it easier to use in vapor deposition processes.

Applicants believe that the stability of {Mn[N(SiMe₂Et)₂]₂}₂ will permit conformal step coverage inside holes and trenches with aspect ratios ranging from 3:1 to 50:1, preferably 5:1 to 10:1, because the precursor will not exhibit the degradation of the analogous precursors. Additionally, as the precursor contains no oxygen, it may be useful in the deposition of pure Mn films. Finally, as the precursor is a liquid, delivery to the reaction chamber is easier than for any of its solid analogs, such as Mn(N(SiMe₃)₂)₂.

It will be understood that many additional changes in the details, materials, steps, and arrangement of parts, which have been herein described and illustrated in order to explain the nature of the invention, may be made by those skilled in the art within the principle and scope of the invention as expressed in the appended claims. Thus, the present invention is not intended to be limited to the specific embodiments in the examples given above and/or the attached drawings.

## Claims

1. A method of depositing a Mn-containing layer on a substrate, the method comprising:
introducing a vapor of a Mn-containing film forming composition into a reactor having a substrate disposed therein, wherein the Mn-containing film forming compositions comprises a silylamide-containing precursor selected from {Mn[N(SiMe₂Et)₂]₂}₂ or Mn[N(SiMe₃)₂]₂(NMeEt₂); and
depositing at least part of the silylamide-containing precursor onto the substrate to form the Mn-containing layer using a vapor deposition method.

2. The method of any one of claim 1, wherein the Mn-containing layer is Mn.

3. The method of any one of claims 1, wherein the Mn-containing layer is MnOSi.

4. The method of any one of claims 1, wherein the Mn-containing layer is MnN.

5. The method of any one of claims 2 to 4, wherein the substrate is SiO₂.

6. A method of depositing a Mn-containing layer on a substrate according to Claim 1, the method comprising:
fluidly connecting a Mn-containing film forming composition delivery device comprising a Mn-containing film forming composition to a vapor deposition chamber, wherein the Mn-containing film forming composition comprises a silylamide-containing precursor selected from the group consisting of {Mn[N(SiMe2Et)2]2}2, or Mn[N(SiMe₃)₂]₂(NMeEt₂); heating the Mn-containing film forming composition delivery device to a temperature that generates between 0.2 Torr (27 Pascal) and 1.5 Torr (200 Pascal) of vapor pressure of the Mn-containing film forming composition;
delivering a vapor of a Mn-containing film forming composition into the vapor deposition chamber having a substrate disposed therein; and
depositing at least part of the silylamide-containing precursor onto the substrate to form the Mn-containing layer using a vapor deposition method.

7. The method of claim 6, further comprising maintaining the Mn-containing film forming composition delivery device at the temperature for a time ranging from 2 weeks to 12 months.

8. A manganese-containing film forming composition comprising a liquid silylamide-containing precursor having the formula {Mn[N(SiMe₂Et)₂]₂}₂ or Mn[N(SiMe₃)₂]₂(NMeEt₂); the liquid silylamide-containing precursor is a liquid at standard temperature and pressure.

## Patentansprüche

1. Verfahren zum Abscheiden einer Mn-haltigen Schicht auf einem Substrat, wobei das Verfahren umfasst:
Einführen eines Dampfes einer Mn-haltigen filmbildenden Zusammensetzung in einen Reaktor, der ein darin angeordnetes Substrat aufweist, wobei die Mn-haltigen filmbildenden Zusammensetzungen einen Silylamid-haltigen Vorläufer umfassen, ausgewählt aus
{Mn[N(SiMe₂Et)₂]₂}₂
oder
Mn[N(SiMe₃)₂]₂(NMeEt₂);
und
Abscheiden von mindestens einem Teil des Silylamid-haltigen Vorläufers auf dem Substrat zur Bildung der Mn-haltigen Schicht unter Verwendung eines Dampfabscheidungsverfahrens.

2. Verfahren nach einem von Anspruch 1, wobei die Mn-haltige Schicht Mn ist.

3. Verfahren nach einem von Ansprüchen 1, wobei die Mn-haltige Schicht MnOSi ist.

4. Verfahren nach einem von Ansprüchen 1, wobei die Mn-haltige Schicht MnN ist.

5. Verfahren nach einem der Ansprüche 2 bis 4, wobei das Substrat SiO₂ ist.

6. Verfahren zum Abscheiden einer Mn-haltigen Schicht auf einem Substrat nach Anspruch 1, wobei das Verfahren umfasst:
fluidisches Verbinden einer Vorrichtung zur Abgabe einer Mn-haltigen filmbildenden Zusammensetzung, die eine Mn-haltige filmbildende Zusammensetzung umfasst, mit einer Dampfabscheidungskammer, wobei die Mn-haltige filmbildende Zusammensetzung einen Silylamid-haltigen Vorläufer umfasst, der aus der Gruppe ausgewählt ist, bestehend aus {Mn[N(SiMe₂Et)₂]₂}₂ oder Mn[N(SiMe₃)₂]₂(NMeEt₂); Erwärmen der Vorrichtung zur Abgabe der Mn-haltigen filmbildenden Zusammensetzung auf eine Temperatur, die einen Dampfdruck der Mn-haltigen filmbildenden Zusammensetzung zwischen 0,2 Torr (27 Pascal) und 1,5 Torr (200 Pascal) erzeugt;
Abgeben eines Dampfes einer Mn-haltigen filmbildenden Zusammensetzung in die Dampfabscheidungskammer, die ein darin angeordnetes Substrat aufweist; und
Abscheiden von mindestens einem Teil des Silylamid-haltigen Vorläufers auf dem Substrat zur Bildung der Mn-haltigen Schicht unter Verwendung eines Dampfabscheidungsverfahrens.

7. Verfahren nach Anspruch 6, weiter umfassend das Halten der Vorrichtung zur Abgabe der Mn-haltigen filmbildenden Zusammensetzung bei der Temperatur für eine Zeitspanne von 2 Wochen bis 12 Monaten.

8. Manganhaltige filmbildende Zusammensetzung, umfassend einen flüssigen Silylamid-haltigen Vorläufer, der die Formel {Mn[N(SiMe₂Et)₂]₂}₂ oder Mn[N(SiMe₃)₂]₂(NMeEt₂) aufweist; wobei der flüssige Silylamid-haltige Vorläufer bei Standardtemperatur und -druck eine Flüssigkeit ist.

## Revendications

1. Procédé de dépôt d'une couche contenant du Mn sur un substrat, le procédé comprenant:
l'introduction d'une vapeur d'une composition filmogène contenant du Mn dans un réacteur présentant un substrat disposé dans celui-ci, dans lequel la composition filmogène contenant du Mn comprend un précurseur contenant du silylamide choisi parmi {Mn[N(SiMe₂Et)₂]₂}₂ ou Mn[N(SiMe₃)₂]₂(NMeEt₂) ; et
le dépôt d'au moins une partie du précurseur contenant du silylamide sur le substrat pour former la couche contenant du Mn à l'aide d'un procédé de dépôt en phase vapeur.

2. Procédé selon la revendication 1, dans lequel la couche contenant du Mn est Mn.

3. Procédé selon la revendication 1, dans lequel la couche contenant du Mn est MnOSi.

4. Procédé selon la revendication 1, dans lequel la couche contenant du Mn est MnN.

5. Procédé selon l'une quelconque des revendications 2 à 4, dans lequel le substrat est SiO₂.

6. Procédé de dépôt d'une couche contenant du Mn sur un substrat selon la revendication 1, le procédé comprenant :
le raccordement fluidique d'un dispositif de distribution de composition filmogène contenant du Mn comprenant une composition filmogène contenant du Mn à une chambre de dépôt en phase vapeur, dans lequel la composition filmogène contenant du Mn comprend un précurseur contenant du silylamide choisi dans le groupe constitué par {Mn[N(SiMe₂Et)₂]₂}₂, ou Mn[N(SiMe₃)₂]₂(NMeEt₂) ; le chauffage du dispositif de distribution de composition filmogène contenant du Mn jusqu'à une température qui génère entre 0,2 Torr (27 Pascal) et 1,5 Torr (200 Pascal) de pression de vapeur de la composition filmogène contenant du Mn ;
la distribution d'une vapeur d'une composition filmogène contenant du Mn dans la chambre de dépôt en phase vapeur présentant un substrat disposé dans celle-ci ; et
le dépôt d'au moins une partie du précurseur contenant du silylamide sur le substrat pour former la couche contenant du Mn à l'aide d'un procédé de dépôt en phase vapeur.

7. Procédé selon la revendication 6, comprenant en outre le maintien du dispositif de distribution de composition filmogène contenant du Mn à la température pendant une durée dans la plage de 2 semaines à 12 mois.

8. Composition filmogène contenant du manganèse comprenant un précurseur contenant du silylamide liquide présentant la formule {Mn[N(SiMe₂Et)₂]₂}₂ ou Mn[N(SiMe₃)₂]₂(NMeEt₂) ; le précurseur contenant du silylamide liquide est un liquide à température et pression normales.
